# EUROPEAN PATENT APPLICATION

(11) **EP 2 986 091 A1**
(43) Date of publication of application: **17.02.2016**
(21) Application number: 15767407.8
(22) Date of filing: 09.02.2015
(51) Int. Cl.: H05K 5/00

(54) **CONTAINER OF DATA CENTRE, AND DATA CENTRE**

(30) Priority: 09.05.2014 CN 201410196553
(71) Applicant: Huawei Technologies Co. Ltd., Shenzhen, Guangdong 518129 (CN)
(72) Inventor: TANG, Yong, Shenzhen Guangdong 518129 (CN); LUO, Xinhui, Shenzhen Guangdong 518129 (CN); XU, Lijun, Shenzhen Guangdong 518129 (CN)
(74) Representative: Maiwald Patentanwalts GmbH
(86) International application number: PCT/CN2015/072571
(87) International publication number: WO 2015/169116

(57) **Abstract**

The present invention relates to the field of electronic device technologies and discloses a container of a data center, and a data center. The container includes a top wall, a bottom wall, a front-end wall, a back-end wall, a first side wall, a second side wall, a top beam, a bottom beam, and a partition plate, multiple cabinet bodies and a sealing plate that are located inside the container, where the first side wall and/or the second side wall is detachably connected to the top beam and the bottom beam, and the top beam is provided with a securing hole of a top beam connection apparatus; the partition plate partitions interior space of a container body into an equipment compartment and an air-conditioner compartment; the multiple cabinet bodies are located inside the equipment compartment and are closely arranged in a direction from the front-end wall towards the back-end wall; and the sealing plate is located inside the equipment compartment, and is in seal fit with the multiple cabinet bodies, the top wall and the first side wall, so as to partition space inside the equipment compartment into a confined cold aisle that is located between the cabinet bodies and the side wall, and a maintenance channel that is located between the cabinet bodies and the second side wall. The foregoing containers can be combined in a set direction according to an actual requirement, so as to obtain a data center that meets the requirement, thereby increasing effects and functions of the data center.

## Description

### TECHNICAL FIELD

The present invention relates to the field of electronic device technologies, and in particular, to a container of a data center, and a data center.

### BACKGROUND

In the field of electronic device technologies, various functional modules for forming a data center are assembled in one container body, so as to form a data center that is characterized by low costs, high integration, high energy efficiency, and favorable flexibility.

Because a quantity and types of cabinet bodies assembled in a single container body are restricted, effects and functions of the cabinet bodies inside the single container body are restricted.

Therefore, how to provide a container, of a data center, that is easily extended is one of technical problems that urgently needs to be resolved by a person skilled in the art.

### SUMMARY

The present invention provides a container of a data center, and a data center, where multiple containers can be combined to form a data center, so that effects and functions of the data center can be increased.

According to a first aspect, a container of a data center is provided, including: a top wall, a bottom wall, a front-end wall, a back-end wall, a first side wall, a second side wall, a top beam, and a bottom beam, where a container body of a cuboid structure is enclosed by the top wall, the bottom wall, the front-end wall, the back-end wall, the first side wall and the second side wall; and the top beam is connected to the top wall, and the bottom beam is connected to the bottom wall; where
the first side wall and/or the second side wall is detachably connected to the top beam and the bottom beam, so that the first side wall and/or the second side wall can be detached when at least two containers form the data center; the top beam is provided with a securing hole used for installing a top beam connection apparatus, and the top beam connection apparatus is configured to: when at least two containers form the data center, connect the at least two containers; and
there are a partition plate, multiple cabinet bodies and a sealing plate inside the container, where the partition plate partitions interior space of the container body into an equipment compartment and an air-conditioner compartment; the multiple cabinet bodies are located inside the equipment compartment and are installed on the bottom wall; the multiple cabinet bodies are closely arranged in a direction from the front-end wall towards the back-end wall; and the sealing plate is located inside the equipment compartment, and is in seal fit with the multiple cabinet bodies, the top wall and the first side wall, so as to partition space inside the equipment compartment into a confined cold aisle that is located between the multiple cabinet bodies and the first side wall, and a maintenance channel that is located between the multiple cabinet bodies and the second side wall.

With reference to the first aspect, in a first possible implementation manner, in a direction from the top wall towards the bottom wall, the top beam includes a first beam body, a connecting plate and a second beam body that are successively arranged, the connecting plate is securely connected to the first beam body and the second beam body, and the securing hole is disposed on the first beam body; and the top wall is connected to the first beam body, and both a top of the first side wall and a top of the second side wall are detachably connected to the second beam body.

With reference to the first possible implementation manner of the first aspect, in a second possible implementation manner, the first beam body is a square-steel beam body, the second beam body is a C-steel beam body, an opening of the second beam body faces an inner side of the container body, and both the top of the first side wall and the top of the second side wall are securely connected to the second beam body by using a fastening bolt; and
the bottom beam is an I-steel bottom beam, and a bottom of the first side wall and a bottom of the second side wall are securely connected to the bottom beam by using a fastening bolt.

With reference to the first aspect, the first possible implementation manner of the first aspect, or the second possible implementation manner of the first aspect, in a third possible implementation manner, the container further includes a fire control pipe located inside the container body, where a port of the fire control pipe is a thread connector.

With reference to the first aspect, the first possible implementation manner of the first aspect, the second possible implementation manner of the first aspect, or the third possible implementation manner of the first aspect, in a fourth possible implementation manner, the container further includes two lifting cable racks that are installed on the top wall of the container body, where one lifting cable rack is configured to lift and install a strong-current cable, the other lifting cable rack is configured to lift and install a weak-current cable, the two lifting cable racks are separated from each other, the lifting cable rack is attached onto a crossbeam, and the crossbeam is connected to the top wall in a direction from the first side wall towards the second side wall.

With reference to the first aspect, the first possible implementation manner of the first aspect, the second possible implementation manner of the first aspect, the third possible implementation manner of the first aspect, or the fourth possible implementation manner of the first aspect, in a fifth possible implementation manner, a bottom wall side edge, parallel to the first side wall, of the bottom wall is bonded to a surface, facing the top wall, of the bottom beam, and both the first side wall and the second side wall are detachably fastened to the surface, facing the top wall, of the bottom beam.

With reference to the first aspect, the first possible implementation manner of the first aspect, the second possible implementation manner of the first aspect, the third possible implementation manner of the first aspect, the fourth possible implementation manner of the first aspect, or the fifth possible implementation manner of the first aspect, in a sixth possible implementation manner, the bottom beam has a lower corner fitting, and the lower corner fitting is provided with a securing hole used for installing a bottom beam connection apparatus; and the bottom beam connection apparatus is configured to: when at least two containers form the data center, connect the at least two containers.

With reference to the first aspect, the first possible implementation manner of the first aspect, the second possible implementation manner of the first aspect, the third possible implementation manner of the first aspect, the fourth possible implementation manner of the first aspect, the fifth possible implementation manner of the first aspect, or the sixth possible implementation manner of the first aspect, in a seventh possible implementation manner, the first side wall is formed by splicing multiple side plates, and the second side wall is formed by splicing multiple side plates.

According to a second aspect, a data center is provided, including at least two containers, where the at least two containers are successively and closely arranged, and in any two adjacent containers:
top walls of the two containers are in seal fit, bottom walls of the two containers are in seal fit, a top beam connection apparatus is disposed between container bodies of the two containers, and the top beam connection apparatus is securely connected to top beams of the two containers by using securing holes on the top beams of the two containers;
the two containers each include an equipment compartment and an air-conditioner compartment, the air-conditioner compartments of the two containers are located at one end of the data center and are interconnected to form a data center air-conditioner compartment, and the equipment compartments of the two containers are located at the other end of the data center; and
each equipment compartment in the equipment compartments of the two containers includes a row of cabinet bodies, and sides, facing each other, of the cabinet bodies of the two containers fit to form a data center confined cold aisle or a data center maintenance channel.

With reference to the second aspect, in a first possible implementation manner, the data center includes at least three containers that are successively and closely arranged, and data center confined cold aisles and data center maintenance channels, which are formed between cabinet bodies of the at least three containers that are successively and closely arranged, are distributed alternately.

With reference to the second aspect, in a second possible implementation manner, for any two closely-adjacent containers, a bottom beam connection apparatus is disposed between a bottom beam of one container and a bottom beam of the other container, and the bottom beam connection apparatus is securely connected to bottom beams of the two containers by using securing holes on lower corner fittings of the bottom beams of the two containers.

With reference to the second aspect, or the first possible implementation manner of the second aspect, in a second possible implementation manner, each container in the any two closely-adjacent containers is provided with a fire control pipe, and when a port of the fire control pipe is a thread connector, for any two closely-adjacent containers, ports of the fire control pipes inside container bodies of the containers are connected by using a hose.

According to the container of the data center provided in the first aspect and the data center provided in the second aspect, in the container of the data center, a first side wall and/or a second side wall of a container body is detachably connected to a top beam and a bottom beam, when only a single container is used, both the first side wall and the second side wall of the container body of the container are installed on the corresponding top beam and bottom beam of the container body of the container, and a confined cold aisle may be formed inside the container body; when multiple containers need to be successively and closely arranged and combined to form the data center provided in the second aspect, two adjacent side walls in any two closely-adjacent containers are removed, an air-conditioner compartment of one container and an air-conditioner compartment of the other container are located at a same end of the containers and are interconnected, top walls of the two containers are in seal fit, bottom walls of the two containers are in seal fit, a top beam connection apparatus is disposed between container bodies of the two containers, and the top beam connection apparatus is securely connected to top beams of the two containers by using securing holes on the top beams of the two containers, so that combination of the container bodies of the two containers is implemented, and the combined container bodies of the two closely-adjacent containers satisfy a requirement on sealing performance of the data center; sides, facing each other, of the cabinet bodies of the any two closely-adjacent containers fit to form a data center confined cold aisle or a data center maintenance channel; where
when sides, facing each other, of the cabinet bodies of the two closely-adjacent containers fit to form a data center confined cold aisle, sealing plates in the two containers are in seal fit, so that a data center confined cold aisle with relatively large space is formed inside the data center after combination of the two containers, thereby implementing heat and cold insulation inside the data center after combination of the two containers; and
when sides, facing each other, of the cabinet bodies of the two containers fit to form a data center maintenance channel, maintenance channels of the two containers are interconnected, thereby increasing a width of the maintenance channel inside the data center after combination of the two containers, and facilitating maintenance inside the data center.

Therefore, the foregoing containers provided in the present invention can be combined in a set direction according to an actual requirement, so as to obtain a data center that meets the requirement, thereby increasing effects and functions of the data center.

### BRIEF DESCRIPTION OF DRAWINGS

To describe the technical solutions in the embodiments of the present invention more clearly, the following briefly introduces the accompanying drawings required for describing the embodiments. Apparently, the accompanying drawings in the following description show merely some embodiments of the present invention, and a person of ordinary skill in the art may still derive other drawings from these accompanying drawings without creative efforts.
FIG. 1 is a schematic structural diagram of two assembled adjacent containers in a data center according to the present invention;
FIG. 2 is a schematic structural diagram of combination of cabinet bodies and sealing plates in two adjacent containers in the data center of a structure shown in FIG. 1;
FIG. 3 is a schematic structural diagram of combination between top walls and bottom walls of cabinet bodies of two containers in two adjacent containers in the data center of a structure shown in FIG. 1; and
FIG. 4 is a schematic principle diagram of a data center according to the present invention.

### DESCRIPTION OF EMBODIMENTS

The following clearly and completely describes the technical solutions in the embodiments of the present invention with reference to the accompanying drawings in the embodiments of the present invention. Apparently, the described embodiments are merely some but not all of the embodiments of the present invention. All other embodiments obtained by a person of ordinary skill in the art based on the embodiments of the present invention without creative efforts shall fall within the protection scope of the present invention.

Embodiments of the present invention provide a container of a data center, and a data center. The container is convenient for combination, and a data center that meets effect and function requirements can be obtained after the combination. The circuit board and a method for distributing a surface-layer high-speed differential lines of the circuit board are described in the following with reference to the accompanying drawings.

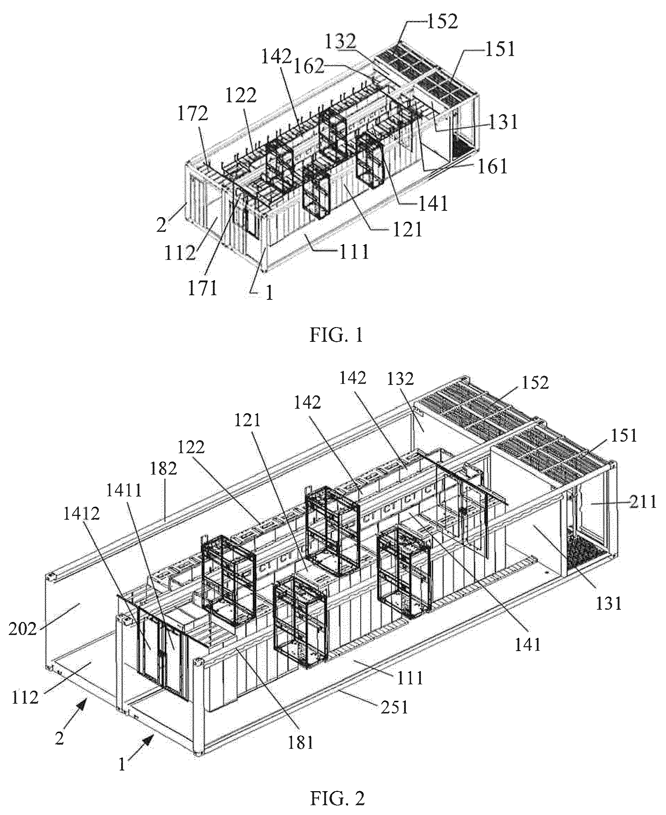

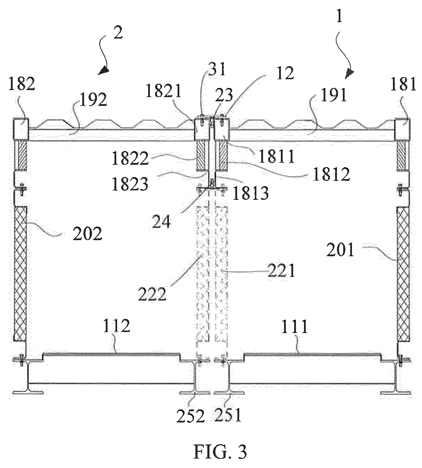

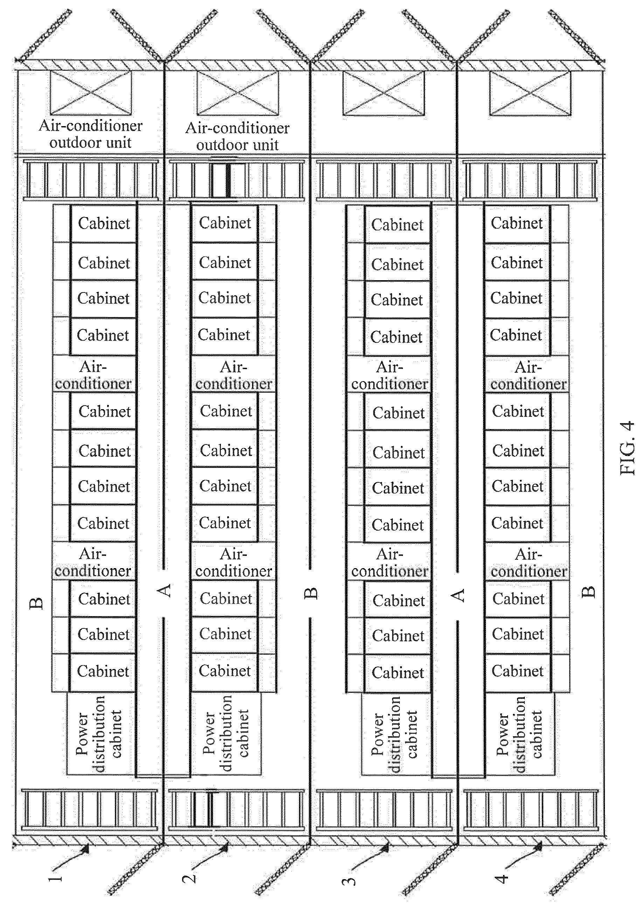

Referring to FIG. 1, FIG. 2, FIG. 3 and FIG. 4, FIG. 1 is a schematic structural diagram of two assembled adjacent containers in a data center according to the present invention, FIG. 2 is a schematic structural diagram of combination of cabinet bodies and sealing plates in two adjacent containers in the data center of a structure shown in FIG. 1, FIG. 3 is a schematic structural diagram of combination between top walls and bottom walls of cabinet bodies of two containers in two adjacent containers in the data center of a structure shown in FIG. 1, and FIG. 4 is a schematic principle diagram of a data center according to the present invention.

For ease of description, in the embodiments, descriptions of concepts such as "data center" and "top beam connection apparatus" are introduced when a structure and a combination principle of the container are described, and the data center is not described individually in the following.

As shown in FIG. 1 and FIG. 2, a container of a data center is provided in an embodiment of the present invention, that is, a container 1 and a container 2 shown in FIG. 2. The container of the data center provided in this embodiment of the present invention includes a container body, and a partition plate, multiple cabinet bodies and a sealing plate that are located inside the container body. The container 1 shown in FIG. 2 and FIG. 3 is used as an example.

As shown in FIG. 2 and FIG. 3, the container 1 of the data center includes a top wall 191, a bottom wall 111, a front-end wall, a back-end wall 211, two side walls, a top beam 181, and a bottom beam 251. The two side walls are a second side wall 201 and a first side wall 221 shown in FIG. 3. A cuboid structure is enclosed by the top wall 191, the bottom wall 111, the front-end wall, the back-end wall 211, the second side wall 201 and the first side wall 221 of the container 1. The top wall 191 is connected to the top beam 181, and the bottom wall 111 is securely connected to the bottom beam 251.

The second side wall 201 and/or the first side wall 221 is detachably connected to the corresponding top beam 181 and bottom beam 251, so that the first side wall 221 and/or the second side wall 201 can be detached when at least two containers are combined to form the data center; the top beam 181 is provided with a securing hole used for installing a top beam connection apparatus 12; and the top beam connection apparatus 12 is configured to: when at least two containers form the data center, connect the at least two containers. Specifically, the top beam connection apparatus 12 is connected to top beams of two containers by using a bolt 31.

As shown in FIG. 1 and FIG. 2, a partition plate 131 inside the container 1 partitions interior space of the container 1 into an equipment compartment and an air-conditioner compartment 151. The equipment compartment and the air-conditioner compartment 151 are arranged in a direction from the front-end wall towards the back-end wall 211. The air-conditioner compartment 151 is configured to install an air-conditioner outdoor unit. Preferably, the air-conditioner outdoor unit is installed on the back-end wall 211.

As shown in FIG. 1 and FIG. 2, multiple cabinet bodies 121 inside the container 1 are located inside the equipment compartment and are installed on the bottom wall 111, and the multiple cabinet bodies 121 are closely arranged in a direction from the front-end wall towards the back-end wall 211, as shown in FIG. 1 and FIG. 2.

As shown in FIG. 1 and FIG. 2, a sealing plate 141 inside the container 1 is located inside the equipment compartment, and the sealing plate 141 is in seal fit with the multiple cabinet bodies 121, the top wall 191 and the first side wall 221, so as to partition interior space inside the equipment compartment into a confined cold aisle that is located between the cabinet bodies 121 and the first side wall 221, and a maintenance channel that is located between the cabinet bodies 121 and the second side wall 201.

In the container 1 provided in the foregoing embodiment, the first side wall 221 is detachably connected to the top beam 181 and the bottom beam 251. When only the container 1 is used, the second side wall 201 and the first side wall 221 of the container body of the container 1 are both installed on the corresponding top beam 181 and bottom beam 251, and a confined cold aisle may be formed inside the container body, thereby implementing heat and cold insulation of space of the container body inside the container.

When multiple containers need to be successively and closely arranged and combined to form a data center provided in the second aspect, two adjacent side walls in any two closely-adjacent containers are removed, an air-conditioner compartment of one container and an air-conditioner compartment of the other container are located at a same end of the containers and are interconnected, top walls of the two containers are in seal fit, bottom walls of the two containers are in seal fit, a top beam connection apparatus is disposed between container bodies of the two containers, and the top beam connection apparatus is securely connected to top beams of the two containers by using securing holes on the top beams of the two containers, so that combination of the container bodies of the two containers is implemented, and the combined container bodies of the two closely-adjacent containers satisfy a requirement on sealing performance of the data center; and sides, facing each other, of the cabinet bodies of the any two closely-adjacent containers fit to form a data center confined cold aisle or a data center maintenance channel.

When sides, facing each other, of the cabinet bodies of the two closely-adjacent containers fit to form a data center confined cold aisle, sealing plates in the two containers are in seal fit, so that a data center confined cold aisle with relatively large space is formed inside the data center after combination of the two containers, thereby implementing heat and cold insulation inside the data center after combination of the two containers. The container 1 and the container 2 shown in FIG. 3 and FIG. 4 are used as an example. As shown in FIG. 2 and FIG. 3, the first side wall 221, in the container 1, adjacent to the container 2 is removed, a first side wall 222, in the container 2, adjacent to the container 1 is removed, the sealing plate 141 of the container 1 and a sealing plate 142 of the container 2 are in seal fit, and a partition plate 132 of the container 2 and the partition plate 131 of the container 1 are spliced, so that a confined cold aisle in the container 1 and a confined cold aisle in the container 2 are interconnected, and a data center confined cold aisle A shown in FIG. 4 is formed between the cabinet bodies 121 of the container 1 and cabinet bodies 122 of the container 2, thereby implementing heat and cold insulation inside the data center after combination of the container 1 and the container 2. In addition, as shown in FIG. 3, the top beam 181 of the container body of the container 1 is securely connected to a top beam 182 of the container body of the container 2 by using the top beam connection apparatus, and a sealing rubber strip is disposed between the top wall 191 of the container 1 and a top wall 192 of the container 2, so that a requirement on sealing performance of the data center is satisfied after combination of the container 1 and the container 2.

When sides, facing each other, of the cabinet bodies of the two containers fit to form a data center maintenance channel, maintenance channels of the two containers are interconnected, thereby increasing a width of the maintenance channel inside the data center after combination of the two containers, and facilitating maintenance inside the data center. Referring to FIG. 3 and FIG. 4, the container 2 and a container 3 shown in FIG. 4 are used as an example. A second side wall 202, in the container 2, adjacent to the container 3 is removed, a second side wall, in the container 3, adjacent to the container 2 is removed, so that maintenance channels of the container 2 and the container 3 are interconnected to form a data center maintenance channel B with a larger width; and after combination of the container 2 and the container 3, a width of the data center maintenance channel is increased, thereby facilitating maintenance. In addition, container bodies of the container 2 and the container 3 are securely connected by using the top beam connection apparatus and securing holes on top beams, and a sealing rubber strip is disposed between top walls of the container bodies of the container 2 and the container 3, so that a requirement on sealing performance of the data center is satisfied after splicing of the container 2 and the container 3.

Preferably, to ensure connection stability of any two adjacent containers that are combined, for any two adjacent containers, a bottom beam connection apparatus is disposed between a bottom beam of one container and a bottom beam of the other container, the bottom beam of each container is provided with a lower corner fitting, the lower corner fitting is provided with a securing hole, and the bottom beam connection apparatus between the bottom beams of the two containers is securely connected to the lower corner fitting by using the securing hole on the lower corner fitting, so that secure connection between the bottom beams of the two containers is implemented, and relatively high connection stability of the any two adjacent containers that are combined is achieved.

Preferably, when a maintenance channel in one container is located at a side, of cabinet bodies inside the container, away from the other container, as shown in FIG. 1 and FIG. 2, what is formed after combination of the container 1 and the container 2 may be referred to as a container unit.

As shown in FIG. 3, when the data center includes only a container unit formed by combination of the container 1 and the container 2, the second side wall 201 of the container 1 is reserved, and the second side wall 202 of the container 2 is reserved. As shown in FIG. 3, when the container 1 and the container 2 are combined, the container body of the container 1 is securely connected to the container body of the container 2 by using the top beam connection apparatus 12, the securing hole of the top beam 181 of the container 1, and the securing hole of the top beam 182 of the container 2, and sealing rubber strips are disposed between the top beam 181 of the container 1 and the top beam 182, as a sealing rubber strip 23 and a sealing rubber strip 24 shown in FIG. 3, so as to ensure sealing performance during combination of the container body of the container 1 and the container body of the container 2. After the combination, the top wall 191 of the container 1 and the top wall 192 of the container 2 jointly form a top wall of the data center.

In addition, as shown in FIG. 1 and FIG. 2, the air-conditioner compartment 151 of the container 1 is adjacent to an air-conditioner compartment 152 of the container 2, so that the container unit formed by combination of the container 1 and the container 2 can run independently; and in the container body of the container 1 and the container body of the container 2, a confined cold aisle in the container body of the container 1 and a confined cold aisle in the container body of the container 2 are interconnected to form a data center confined cold aisle, thereby ensuring cooling performance of the container unit formed by combination of the container 1 and the container 2.

As shown in FIG. 4, when the data center includes multiple container units, in any two adjacent container units, a second side wall that is corresponding to a maintenance channel and in container bodies of any two adjacent containers is removed, and then combination is performed. A sealing rubber strip is disposed between top walls of container bodies of the two combined containers, and the container bodies of the two containers are securely connected by using a top beam connection apparatus and a securing hole on a top beam; and air-conditioner compartments of the container bodies of the two containers are adjacent, bottom walls of the container bodies of the two adjacent containers are securely connected, and maintenance channels of the container bodies of the two adjacent containers are interconnected. A data center confined cold aisle A is formed between two containers in each container unit, other interior space of the data center may form a data center maintenance channel B.

In the data center that is obtained by combination of the foregoing containers, heat and cold insulation can be implemented, a width of a confined cold aisle is increased, and a maintenance channel between any two adjacent container units is increased, which facilitates maintenance of devices such as a cabinet body in a container body.

Therefore, the foregoing containers provided in the present invention can be combined in a set direction according to an actual requirement, so as to obtain a data center that meets the requirement, thereby increasing effects and functions of the data center.

As shown in FIG. 2, in an embodiment, to enable maintenance personnel to easily enter a confined cold aisle, a side plate, in the confined cold aisle, that faces an end of a front-end wall of a container body forms a door body. When the door body is opened, a maintenance channel of the container is interconnected to the confined cold aisle, which enables the maintenance personnel to easily enter the confined cold aisle to perform equipment maintenance.

As shown in FIG. 2, a door body 1411 is formed in a confined cold aisle in a container 1, and a door body 1412 is formed in a confined cold aisle in a container 2.

As shown in FIG. 3, in an embodiment, a container body of a container 1 is used as an example. Each top beam 181 of the container 1 includes a first beam body 1811, a connecting plate 1812 and a second beam body 1813 that are successively arranged in a direction from a top wall 191 towards a bottom wall 111. The connecting plate 1812 is securely connected to the first beam body 1811 and the second beam body 1813. The securing hole mentioned in the foregoing implementation manner and used for installing a top beam connection apparatus is disposed on the first beam body 1811. The top wall 191 is securely connected to the first beam body 1811 of each top beam 181, and tops of a second side wall 201 and a first side wall 221 are detachably connected to the second beam body 1813 of one top beam 181 that is parallel to the tops.

The bottom wall 111 is securely connected to each bottom beam 251, and bottoms of the second side wall 201 and the first side wall 221 are detachably and securely connected to one bottom beam 251 that is parallel to the bottoms.

Similarly, each top beam 182 of a container 2 includes a first beam body 1821, a connecting plate 1822 and a second beam body 1823 that are successively arranged in a direction from a top wall 192 towards a bottom wall 112. The connecting plate 1822 is securely connected to the first beam body 1821 and the second beam body 1823. The securing hole used for installing a top beam connection apparatus is disposed on the first beam body 1821. The top wall 192 is securely connected to each top beam 182, and tops of a second side wall 202 and a first side wall 222 are detachably connected to the second beam body 1823 of one top beam 182 that is parallel to the tops.

The bottom wall 112 is securely connected to each bottom beam 252, and bottoms of the second side wall 202 and the first side wall 222 are detachably and securely connected to one bottom beam 252 that is parallel to the bottoms.

In this way, when the container 1 and the container 2 are combined, a sealing rubber strip 23 may be disposed between the first beam body 1811 of the top beam 181 of the container 1 and the first beam body 1821 of the top beam 182 of the container 2, and a sealing rubber strip 24 is disposed between the second beam body 1813 of the top beam 181 of the container 1 and the second beam body 1823 of the top beam 182 of the container 2, so that two-layer sealing is implemented and sealing performance at the top walls is improved after combination of the container 1 and the container 2.

Specifically, as shown in FIG. 4, the container 1 is still used as an example. In the top beam 181 of the container body of the container 1, the first beam body 1811 is a square-steel beam body, the second beam body 1813 is of a C-steel, an opening of the second beam body 1813 faces an inner side of the container body, and the tops of the second side wall 201 and the first side wall 221 are securely connected to the second beam body 1813 by using a fastening bolt.

The bottom beam 251 of the container body of the container 1 is an I-steel bottom beam, and the bottoms of the second side wall 201 and the first side wall 221 are securely connected to the bottom beam 251 by using a fastening bolt.

Structures of the top beam 181 and the bottom beam 251, a connection manner between the second side wall 201 and the first side wall 221, and the second beam body 1813, and a connection manner between the second side wall 201 and the first side wall 221, and the bottom beam 251 are convenient for assembly and disassembly.

A portion at which the second side wall 201 and the first side wall 221 are connected to the second beam body 1813 has a C-steel structure of which an opening faces an inner side of the container body, and a portion at which the second side wall 201 and the first side wall 221 are connected to the bottom beam 251 has a C-steel structure of which an opening faces an outer side of the container body, which further improves convenience of assembly and disassembly of the second side wall 201 and the first side wall 221. In addition, after the second side wall 201 and first side wall 221 are assembled with the corresponding second beam body 1813 and bottom beam 251, sealing performance of the container body of the container 1 can be further ensured in a better way.

In an embodiment, the container further includes a fire control pipe inside the container body, and a port of the fire control pipe is a thread connector. For the fire control pipe of the foregoing structure, after multiple containers are assembled, a hose can be connected between fire control pipes of container bodies of adjacent containers, so that fire control pipes inside a data center that is formed after the assembly is performed are integrally connected.

In an embodiment, each container further includes two lifting cable racks that are installed on a top wall of a container body. One lifting cable rack is configured to lift and install a strong-current cable, the other lifting cable rack is configured to lift and install a weak-current cable, and the two lifting cable racks are separated from each other. Each lifting cable rack is attached onto a crossbeam, and the crossbeam is connected to the top wall in a direction from a first side wall towards a second side wall.

Specifically, each lifting cable rack is attached onto one crossbeam; and in two crossbeams, one crossbeam is disposed at an end, of an equipment compartment of the container body, adjacent to a front-end wall, and the other crossbeam is disposed at an end, of the equipment compartment of the container body, adjacent to a partition plate, so as to facilitate separation of the two lifting cable racks.

The lifting cable rack of the foregoing structure can implement separation of a strong current and a weak current in each container; and when multiple containers are assembled to form a data center, for any two adjacent containers, crossbeams of lifting cable rack holders for lifting a weak-current line are spliced, and crossbeams of lifting holders for lifting a strong-current line are spliced, so as to implement separation of the strong-current line and the weak-current line in the formed data center. The container 1 and the container 2 shown in FIG. 1 are used as an example. In the container 1, one lifting cable rack is attached onto a crossbeam 171, and the other lifting cable rack is attached onto a crossbeam 161; and in the container 2, one lifting cable rack is attached onto a crossbeam 172, and the other lifting cable rack is attached onto a crossbeam 162. After combination of the container 1 and the container 2, the crossbeam 171 and the crossbeam 172 are spliced, and the crossbeam 161 and the crossbeam 162 are spliced.

In each container, a bottom wall is securely connected to a bottom beam, and a first side wall and/or a second side wall is detachably and securely connected to the bottom beam, which may be specifically as follows:
In the bottom wall, each side edge parallel to a side wall is bonded to a corresponding surface, facing a top wall, of the bottom beam, and the side wall is detachably secured to the surface, facing the top wall, of the bottom beam.

As shown in FIG. 3, the container 1 and the container 2 are used as an example. In a bottom wall 111 of the container 1, a surface, facing a top wall 191, of the bottom wall 111 is higher than a surface, facing the top wall 191, of a bottom beam 251, and two side edges, parallel to a first side wall 221, of the bottom wall 111 are separately bonded to two corresponding surfaces, facing the top wall 191, of the bottom beam 251, and lower portions of the first side wall 221 and the second side wall 201 are detachably secured to the surface, facing the top wall 191, of the bottom beam 251. Similarly, a surface, facing a top wall 192, of a bottom wall 112 of the container 2 is higher than a surface, facing the top wall 192, of a bottom beam 252, and two side edges, parallel to a first side wall 222, of the bottom wall 112 are separately bonded to two corresponding surfaces, facing the top wall 192, of the bottom beam 252, and lower portions of the first side wall 222 and the second side wall 202 are detachably secured to the surface, facing the top wall 192, of the bottom beam 252. Therefore, after the container 1 and the container 2 are assembled, a sealing groove that uses surfaces, facing the top beam, of the adjacent bottom beam 251 and bottom beam 252 as a groove bottom may be formed, and then a sealing rubber strip is disposed inside the sealing groove, so as to ensure sealing performance of a bottom wall formed after the container 1 and the container 2 are assembled.

In an embodiment, each side wall of the container body of the container is formed by splicing multiple side plates.

In this way, when multiple containers are assembled, side plates to be removed may be selected, so as to form different channels in the data center.

A data center provided in an embodiment of the present invention includes at least two containers, where the at least two containers are successively and closely arranged.

Each container includes a top wall, a bottom wall, a front-end wall, a back-end wall, a top beam and a bottom beam; the top beam is connected to the top wall, the bottom beam is connected to the bottom wall; the top beam is provided with a securing hole used for installing a top beam connection apparatus; there are a partition plate, a row of cabinet bodies and a sealing plate inside the container; the partition plate partitions interior space of the container into an equipment compartment and an air-conditioner compartment; the row of cabinet bodies are located inside the equipment compartment and are installed on the bottom wall; the row of cabinet bodies are closely arranged in a direction from the front-end wall towards the back-end wall; and the sealing plate is located inside the equipment compartment and is in seal fit with the row of cabinet bodies and the top wall. In the containers that are successively and closely arranged, one side, facing away from another container, of a container at ends of two sides has a side wall; as shown in FIG. 4, in a container 1, a container 2, a container 3 and a container 4 that are successively and closely arranged, one side, facing away from the container 2, of the container 1 has a side wall, and one side, facing away from the container 3, of the container 4 has a side wall. In any two closely-adjacent containers:
top walls of the two containers are in seal fit, bottom walls of the two containers are in seal fit, a top beam connection apparatus is disposed between container bodies of the two containers, and the top beam connection apparatus is securely connected to top beams of the two containers by using securing holes on the top beams of the two containers, to implement connection of tops of the two containers;
air-conditioner compartments of the two containers are located at one end of the data center, the air-conditioner compartments of the two containers are interconnected to form a data center air-conditioner compartment, and equipment compartments of the two containers are located at the other end of the data center; and
between two rows of cabinet bodies in the equipment compartments of the two containers, sides, facing each other, of the two rows of cabinet bodies can fit to form a data center confined cold aisle or a data center maintenance channel by using sealing plates of the two containers, cabinet walls of the two rows of cabinet bodies, top walls and bottom walls of the two containers. As shown in FIG. 4, sides, facing each other, of two rows of cabinet bodies in equipment compartments of the container 1 and the container 2 fit to form a data center confined cold aisle A, and sides, facing each other, of two rows of cabinet bodies in equipment compartments of the container 2 and the container 3 fit to form a data center maintenance channel B. In addition, because the container 1 is a container at an end of one side of the four containers that are successively and closely arranged in the data center shown in FIG. 4, a data center maintenance channel B is formed between a row of cabinet bodies in the container 1 and a side wall of the container 1. Similarly, a data center maintenance channel B is formed between a row of cabinet bodies in the container 4 and a side wall of the container 4.

In an embodiment, referring to FIG. 4, the data center includes at least three containers that are successively and closely arranged, and data center confined cold aisles and data center maintenance channels, which are formed between cabinet bodies of the at least three containers that are successively and closely arranged, are distributed alternately. As shown in FIG. 4, the data center includes a container 1, a container 2, a container 3 and a container 4. Sides, facing each other, of two rows of cabinet bodies in equipment compartments of the container 1 and the container 2 fit to form a data center confined cold aisle A; sides, facing each other, of two rows of cabinet bodies in equipment compartments of the container 2 and the container 3 fit to form a data center maintenance channel B; sides, facing each other, of two rows of cabinet bodies in equipment compartments of the container 3 and the container 4 fit to form a data center confined cold aisle A. In this case, the data center confined cold aisles A and the data center maintenance channel B that are formed between multiple rows of cabinet bodies in the data center shown in FIG. 4 are distributed alternately.

In an exemplary implementation manner, between any two closely-adjacent containers, a bottom beam connection apparatus is disposed between a bottom beam of one container and a bottom beam of the other container, and the bottom beam connection apparatus is securely connected to the bottom beams of the two containers by using securing holes on lower corner fittings of the bottom beams of the two containers.

Obviously, a person skilled in the art can make various modifications and variations to the embodiments of the present invention without departing from the spirit and scope of the present invention. The present invention is intended to cover these modifications and variations provided that they fall within the scope defined by the following claims and their equivalent technologies.

## Claims

1. A container of a data center, comprising a top wall, a bottom wall, a front-end wall, a back-end wall, a first side wall, a second side wall, a top beam, and a bottom beam, wherein a container body of a cuboid structure is enclosed by the top wall, the bottom wall, the front-end wall, the back-end wall, the first side wall and the second side wall; and the top beam is connected to the top wall, and the bottom beam is connected to the bottom wall; wherein
the first side wall and/or the second side wall is detachably connected to the top beam and the bottom beam, so that the first side wall and/or the second side wall can be detached when at least two containers form the data center; the top beam is provided with a securing hole used for installing a top beam connection apparatus, and the top beam connection apparatus is configured to: when at least two containers form the data center, connect the at least two containers; and
there are a partition plate, multiple cabinet bodies and a sealing plate inside the container, where the partition plate partitions interior space of the container into an equipment compartment and an air-conditioner compartment; the multiple cabinet bodies are located inside the equipment compartment and are installed on the bottom wall; the multiple cabinet bodies are closely arranged in a direction from the front-end wall towards the back-end wall; and the sealing plate is located inside the equipment compartment, and is in seal fit with the multiple cabinet bodies, the top wall and the first side wall, so as to partition space inside the equipment compartment into a confined cold aisle that is located between the multiple cabinet bodies and the first side wall, and a maintenance channel that is located between the multiple cabinet bodies and the second side wall.

2. The container according to claim 1, wherein, in a direction from the top wall towards the bottom wall, the top beam comprises a first beam body, a connecting plate and a second beam body that are successively arranged, the connecting plate is securely connected to the first beam body and the second beam body, and the securing hole is disposed on the first beam body; and the top wall is connected to the first beam body, and both a top of the first side wall and a top of the second side wall are detachably connected to the second beam body.

3. The container according to claim 2, wherein the first beam body is a square-steel beam body, the second beam body is a C-steel beam body, an opening of the second beam body faces an inner side of the container body, and both the top of the first side wall and the top of the second side wall are securely connected to the second beam body by using a fastening bolt; and
the bottom beam is an I-steel bottom beam, and a bottom of the first side wall and a bottom of the second side wall are securely connected to the bottom beam by using a fastening bolt.

4. The container according to any one of claims 1 to 3, further comprising a fire control pipe located inside the container body, wherein a port of the fire control pipe is a thread connector.

5. The container according to any one of claims 1 to 4, further comprising two lifting cable racks that are installed on the top wall of the container body, wherein one lifting cable rack is configured to lift and install a strong-current cable, the other lifting cable rack is configured to lift and install a weak-current cable, the two lifting cable racks are separated from each other, the lifting cable rack is attached onto a crossbeam, and the crossbeam is connected to the top wall in a direction from the first side wall towards the second side wall.

6. The container according to any one of claims 1 to 5, wherein a bottom wall side edge, parallel to the first side wall, of the bottom wall is bonded to a surface, facing the top wall, of the bottom beam, and both the first side wall and the second side wall are detachably fastened to the surface, facing the top wall, of the bottom beam.

7. The container according to any one of claims 1 to 6, wherein the bottom beam has a lower corner fitting, and the lower corner fitting is provided with a securing hole used for installing a bottom beam connection apparatus; and the bottom beam connection apparatus is configured to: when at least two containers form the data center, connect the at least two containers.

8. The container according to any one of claims 1 to 7, wherein the first side wall is formed by splicing multiple side plates, and the second side wall is formed by splicing multiple side plates.

9. A data center, comprising at least two containers, wherein the at least two containers are successively and closely arranged, and in any two adjacent containers:
top walls of the two containers are in seal fit, bottom walls of the two containers are in seal fit, a top beam connection apparatus is disposed between container bodies of the two containers, and the top beam connection apparatus is securely connected to top beams of the two containers by using securing holes on the top beams of the two containers;
the two containers each comprise an equipment compartment and an air-conditioner compartment, the air-conditioner compartments of the two containers are located at one end of the data center and are interconnected to form a data center air-conditioner compartment, and the equipment compartments of the two containers are located at the other end of the data center; and
each equipment compartment in the equipment compartments of the two containers comprises a row of cabinet bodies, and sides, facing each other, of the cabinet bodies of the two containers fit to form a data center confined cold aisle or a data center maintenance channel.

10. The data center according to claim 9, wherein the data center comprises at least three containers that are successively and closely arranged, and data center confined cold aisles and data center maintenance channels, which are formed between cabinet bodies of the at least three containers that are successively and closely arranged, are distributed alternately.

11. The data center according to claim 9, wherein, for any two closely-adjacent containers, a bottom beam connection apparatus is disposed between a bottom beam of one container and a bottom beam of the other container, and the bottom beam connection apparatus is securely connected to bottom beams of the two containers by using securing holes on lower corner fittings of the bottom beams of the two containers.

12. The data center according to any one of claims 9 to 11, wherein each container in the any two closely-adjacent containers is provided with a fire control pipe, and when a port of the fire control pipe is a thread connector, for any two closely-adjacent containers, ports of the fire control pipes inside container bodies of the containers are connected by using a hose.
